# EUROPEAN PATENT SPECIFICATION

(11) **EP 1 067 828 B1**
(45) Date of publication and mention of the grant of the patent: **16.07.2008**
(21) Application number: 00110030.4
(22) Date of filing: 12.05.2000
(51) Int. Cl.: H05F 3/04

(54) **Instantaneous balance control scheme for ionizer**
Sorfortiges Balancesteuerungsablauf für einen Ionisator
Schema de contrôle instantané d'équilibre pour ioniseur

(30) Priority: 06.07.1999 US 347671
(43) Date of publication of application: 10.01.2001
(73) Proprietor: ILLINOIS TOOL WORKS INC., Glenview, Cook County, Illinois 60025 (US)
(72) Inventor: Good, Timothy A., Roversford, Pennsylvania 19468 (US)
(74) Representative: Vetter, Ewald Otto

(56) References cited:
- US-A- 4 809 127
- US-A- 4 974 115

## Description

### BACKGROUND OF THE INVENTION

Controlling static charge is an important issue in semiconductor manufacturing because of its significant impact on the device yields. Device defects caused by electrostatically attracted foreign matter and electrostatic discharge events contribute greatly to overall manufacturing losses.

Many of the processes for producing integrated circuits use non-conductive materials which generate large static charges and complimentary voltage on wafers and devices.

Air ionization is the most effective method of eliminating static charges on non-conductive materials and isolated conductors. Air ionizers generate large quantities of positive and negative ions in the surrounding atmosphere which serve as mobile carriers of charge in the air. As ions flow through the air, they are attracted to oppositely charged particles and surfaces. Neutralization of electrostatically charged surfaces can be rapidly achieved through the process.

Air ionization may be performed using electrical ionizers which generate ions in a process known as corona discharge. Electrical ionizers generate air ions through this process by intensifying an electric field around a sharp point until it overcomes the dielectric strength of the surrounding air. Negative corona occurs when electrons are flowing from the electrode into the surrounding air. Positive corona occurs as a result of the flow of electrons from the air molecules into the electrode.

An ionization system is described in US-A-4974115.

To achieve the maximum possible reduction in static charges from an ionizer of a given output, the ionizer must produce equal amounts of positive and negative ions. That is, the output of the ionizer must be "balanced." If the ionizer is out of balance, the isolated conductor and insulators can become charged such that the ionizer creates more problems than it solves. Ionizers may become imbalanced due to power supply drift, power supply failure of one polarity, contamination of electrodes, degradation of electrodes, or ambient air conditions such as changes in permeability or humidity. In addition, the output of an ionizer may be balanced, but may drop below its desired level due to system component degradation.

Accordingly, ionization systems incorporate monitoring, automatic balancing via feedback systems, and alarms for detecting uncorrected imbalances and out-of-range outputs. Most feedback systems are entirely or primarily hardware-based. Many of these feedback systems cannot provide very fine balance control, since feedback control signals are fixed based upon hardware component values. Furthermore, the overall range of balance control of such hardware-based feedback systems may be limited based upon the hardware component values. Also, many of the hardware-based feedback systems cannot be easily modified since the individual components are dependent upon each other for proper operation.

A charged plate monitor is typically used to calibrate and periodically measure the actual balance of an electrical ionizer. The charged plate monitor is also used to measure static charge decay time. If the decay time is too slow or too fast, the ion output may be adjusted by increasing or decreasing the preset ion current value. This, adjustment is typically performed by adjusting two trim potentiometers (one for positive ion generation and one for negative ion generation).

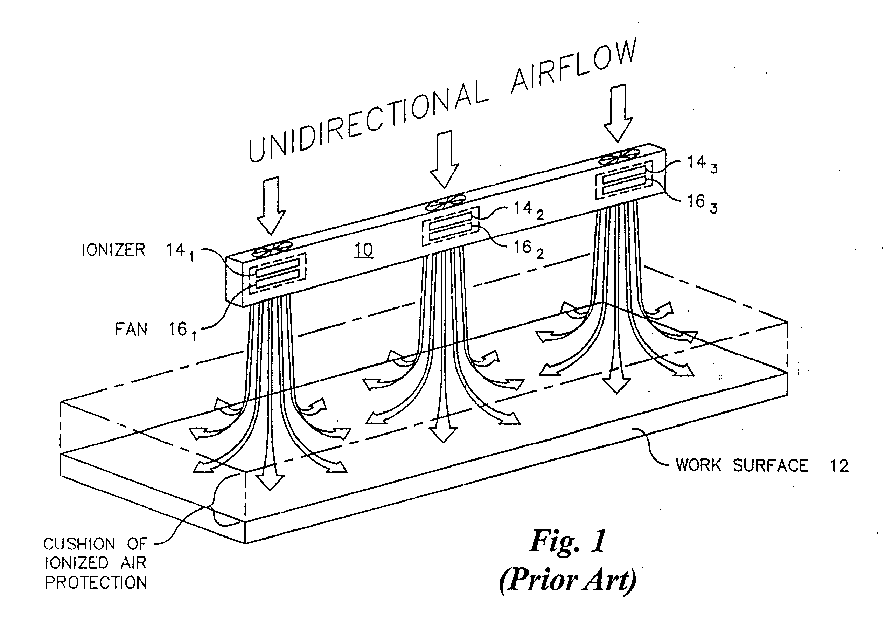

Ionization systems may be used to control static charge in an entire room or in a predefined work surface area. Fig. 1 shows a conventional "overhead ionized air blower" or "overhead ionizer" **10** for controlling static charge on top of work surface **12**. The overhead ionizer **10** provides a cushion of ionized air protection above the work surface **12**, such as from 0-4 inches above the work surface **12**. The overhead ionizer **10** is typically hung over the work surface, such as about 30 inches above the work surface. The overhead ionizer **10** includes therein a plurality of ionizers **14** and a plurality of fans **16**, each fan being associated with one ionizer **14**. One conventional scheme uses three pairs of ionizers **14₁-14₃**/fans **16₁-16₃**. The fans **16** create a unidirectional airflow downward from the ionizer **10** to the work surface **12**. Power is provided to the fans **16** in parallel with the respective ionizers **14** so that both are either on or off. Fan speed can be adjusted, but the adjustment simultaneously adjusts all fans equally.

When a reading from a charged plate monitor detects an ion imbalance or insufficient ion output, the ion balance and/or ion output must be adjusted. Conventional ionizers **14** contain analog trim potentiometers or digital potentiometers for making such adjustments. To make adjustments in a conventional overhead ionizer **10**, a person must reach up to the overhead ionizer **10** to adjust the analog potentiometers or to press UP/DOWN buttons which control digital potentiometer settings. Each ionizer **14₁-14₃** has a separate set of potentiometers. One significant problem with the conventional balance adjustment scheme is that the person's physical movements for performing the adjustment and the physical presence of the person in or near the cushion of ionized air protection interferes with proper adjustment and may introduce sudden, large static charges into the work area.

Automatic balance control systems in conventional ionizers are also inherently limited in how quickly and precisely they can achieve a balanced condition. In a conventional automatic balance control system, imbalances are detected by iteratively measuring balance over a plurality of past time periods and then guessing how to adjust one or both of the positive and negative power supplies to achieve a balanced condition in subsequent time periods. This scheme has at least two significant problems. First, by sampling past time periods to determine subsequent adjustments, the scheme introduces a lag time in the balance adjustments during which time the ionizer is imbalanced. Second, this scheme cannot provide a long-term balanced condition. That is, if the ionizer is too positive for a few milliseconds, the ionizer merely corrects for the excess positive ions by moving towards a balanced condition wherein there are a lesser amount of excess positive ions. No effort is made to compensate for the few milliseconds of being too positive, such as by being too negative by the same amount for a few milliseconds. These two problems limit the ability of conventional balance schemes to provide ideal short-term and long-term balanced conditions.

Accordingly, there is an unmet need for a scheme which allows overhead ionizers to be adjusted without interfering with the static field in the work area to be neutralized. There is also an unmet need for an improved balance adjustment scheme. Furthermore, there is an unmet need to allow ionizer fans to be operated in a more flexible manner with respect to their ionizer. Lastly, there is an unmet need for a fast and precise balance adjustment scheme. The present invention fulfills these needs.

### BRIEF SUMMARY OF THE PRESENT INVENTION

The present invention provides a scheme for balancing positive and negative ion output in an electrical ionizer having positive and negative ion emitters, and positive and negative high voltage power supplies associated with the respective positive and negative ion emitters. In the scheme, at least one of the positive and negative high voltage power supplies switches between a high state and a low state. An ion balance sensor is located close to the ion emitters and outputs a voltage value. An ion balance sensor set point voltage value is stored. The voltage value is set to provide a balanced ion condition in the work space near the electrical ionizer. During operation of the electrical ionizer, the output voltage value of the ion balance sensor is compared with the set point voltage value. One of the switchable high voltage power supplies is switched to a high state when it is detected as a result of the comparison that the output voltage value of the ion balance sensor exceeds the set point voltage value in a first direction by a first predetermined amount, and the one of the switchable high voltage power supplies is switched to a low state when it is detected as a result of the comparison that the output voltage value of the ion balance sensor exceeds the set point voltage value in a second direction by a second predetermined amount, the second direction being opposite of the first direction.

### BRIEF DESCRIPTION OF THE DRAWINGS

The following detailed description of preferred embodiments of the present invention would be better understood when read in conjunction with the appended drawings. For the purpose of illustrating the present invention, there is shown in the drawings embodiments which are presently preferred. However, the present invention is not limited to the precise arrangements and instrumentalities shown. In the drawings:
Fig. 1 is a perspective view of a conventional overhead ionizer;
Fig. 2A is an elevation view of an overhead ionizer of the present invention, taken from a first (front) side of the ionizer, and a wired remote control therefor in accordance with the present invention;
Fig. 2B is an elevation view of an overhead ionizer of the present invention, taken from a second (rear) side of the ionizer, and a wired remote control therefor in accordance with the present invention;
Fig. 3 is a schematic diagram of a plurality of overhead ionizers of Fig. 2A;
Fig. 4 is an exploded view of one ionizer inside of the overhead ionizer of Fig. 2A, and is also a schematic block diagram of microprocessor-controlled circuitry for operating the overhead ionizer of Fig. 2A; and
Fig. 5 is a flowchart of the software associated with the processor of the overhead ionizer shown in Fig. 3.
Fig. 6 is an illustration of waveforms associated with a conventional balance control scheme;
Fig. 7 is a schematic block diagram of a balance control system in accordance with the present invention;
Fig. 8 is a balance sensor waveform generated using the system of Fig. 7 in a first embodiment of the balance control system;
Fig. 9 is a balance sensor waveform generated using the system of Fig. 7 in a second embodiment of the balance control system; and
Fig. 10 is a combined diagram of waveforms associated with the sensor and power supplies of Fig. 7 in a further illustration of the balance control system.

### DETAILED DESCRIPTION OF THE INVENTION

Certain terminology is used herein for convenience only and is not to be taken as a limitation on the present invention. In the drawings, the same reference letters are employed for designating the same elements throughout the several figures.

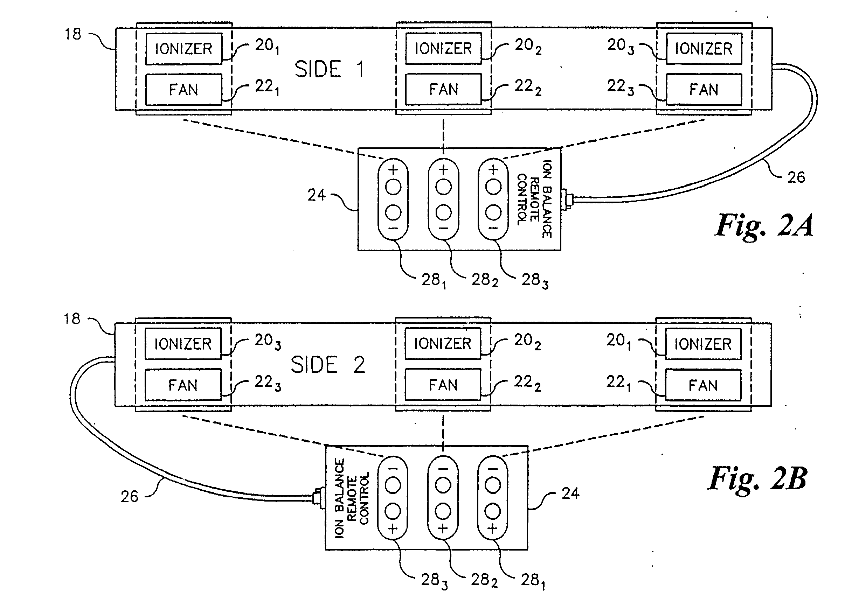

Figs. 2A and 2B show a DC "overhead ionized air blower" or DC "overhead ionizer" **18** for controlling static charge in accordance with the present invention. The overhead ionizer **18** is preferably arranged in the same manner with respect to a work surface as the conventional overhead ionizer **10** of Fig. 1. Like the overhead ionizer **10**, the overhead ionizer **18** includes therein a plurality of electrical ionizers **20** and a plurality of fans **22**, each fan being associated with one ionizer **20**. For example, one preferred embodiment of the invention has three pairs of ionizers **20₁-20₃**/fans **22₁-22₃**.

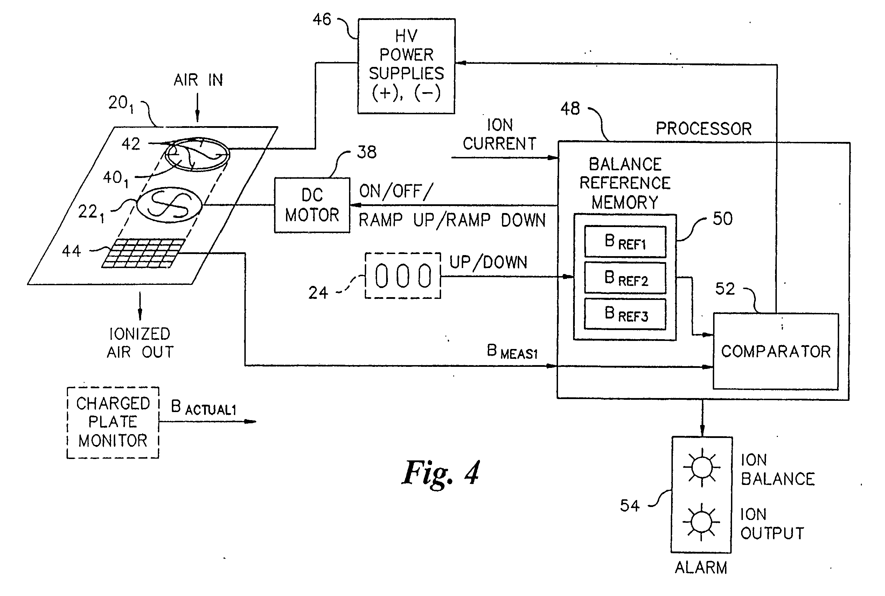

Unlike a conventional ionizer **14** which sets and adjusts balance settings using analog or digital potentiometers, balance settings for the ionizers **20** are stored in memory associated with a microprocessor located inside the housing of the overhead ionizer **18** (shown schematically in Fig. 4). Additional details of the overhead ionizer **18** circuitry are discussed below.

An important feature of the present invention is the use of a wired remote control **24** (shown enlarged with respect to the overhead ionizer **18** for illustration purposes only) for adjusting the balance reference parameter stored in memory. The remote control **24** is wired to the overhead ionizer **18** via detachable cable **26**, which may be a standard modular telephone cable. A length of seven feet is sufficient to allow the user to avoid the "keep out" zone (i.e., the zone where the user's presence and movements interfere with the balance adjustment). The remote control **24** includes a pair of (+)/(-) buttons **28₁-28₃** to control balance for each of the ionizers **20₁-20₃**. The pairs of buttons **28₁-28₃** (generically, **28₁-28ₙ**) are arranged sequentially with respect to each pair. The (+) and (-) buttons within each button pair may be arranged in any particular orientation.

Furthermore, the remote control **24** is designed to have a particular working relationship between the buttons **28**, the ionizers **20** and the cable **26**. Specifically, the button pair **28** nearest the end of the cable **26** which connects to the remote control **24** adjusts the ionizer **20** nearest the end of the cable **26** which connects to the overhead ionizer **18**. Likewise, the button pair **28** farthest from the end of the cable **26** which connects to the remote control **24** adjusts the ionizer **20** farthest from the end of the cable **26** which connects to the overhead ionizer **18**. Intermediate button pairs **28** control respective intermediate ionizers **20** in the same order. This design makes use of the remote control **24** intuitive for the person adjusting the balance. By holding the remote control cable **26** so that it points toward the end of the overhead ionizer **18** that the cable **26** is connected to, the button pairs **28** become oriented in the same order as the ionizers **20** which they control, as shown by the dashed lines in Figs. 2A and 2B. Furthermore, the orientation remains the same regardless of whether the remote control **24** is located facing the front side (side 1) of the overhead ionizer **18** (Fig. 2A), or the rear side (side 2) of the overhead ionizer **18** (Fig. 2B). In addition, adjustments are easy to make even if the cable **26** is twisted or has a tortured path, or if the remote control **24** is held in other orientations with respect to the overhead ionizer **18**, such as rotated 90 degrees. In either instance, the person performing the adjustment need only mentally note the relationship between the button pairs **28**, the ionizers **20** and the cable **26** by following the cable path and visually noting which button pairs **28** and ionizers **18** are closest and farthest from their respective ends of the cable **26**. When using this scheme, it is not necessary to label the individual ionizers **20** or the button pairs **28**.

In an alternative embodiment of the present invention, the cable **26** may be replaced by a wireless system, such as by using a wireless remote control **24** containing an infrared transmitter and providing an infrared receiver on the overhead ionizer **18**.

As discussed above, a person's physical movements which occur while performing the balance adjustment and the physical presence of the person in or near the cushion of ionized air protection interferes with proper adjustment and may introduce sudden, large static charges into the work area. No conventional overhead ionizers which the inventors are aware of provide manual remote control adjustments which allow the adjustments to be made outside of the "keep out" zone and without such interference. Furthermore, conventional remote controls which adjust the same function on different elements of the same units do not provide an intuitive arrangement of adjustment buttons, nor do they account for situations when the units to be adjusted may be approached from different orientations. The design scheme shown in Figs. 2A and 2B is believed to overcome deficiencies in such remote controls.

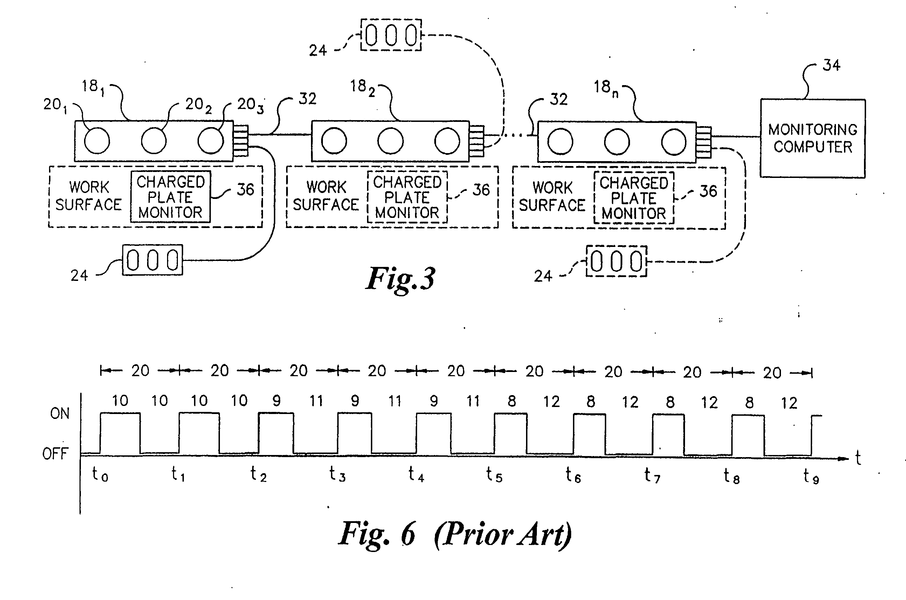

Fig. 3 shows a work area which contains a plurality of overhead ionizers **18₁-18ₙ** connected in a daisy-chain manner by RS-485 communication lines **32** to a monitoring computer **34**. During periodic calibration and/or initial setup, a charged plate monitor **36** is placed on the work surface of overhead ionizer **18₁** to obtain an actual balance reading. If adjustments are necessary, the person making the adjustment plugs in the remote control **24** and adjusts the particular ionizer **20₁**, **20₂** or **20₃** that is most strongly influencing the charged plate monitor **36**. The remote control **24** may be plugged into an unused jack of the communication line connector, as shown in Fig. 3. Alternatively, the communication line **32** may be removed, and the remote control **24** may be plugged therein (not shown). The charged plate monitor **36** may be moved along the work surface to check and adjust the balance of each ionizer **20₁**, **20₂** and **20₃**. Next, the charged plate monitor **36** is moved to the work surface of overhead ionizer **18₂**, the remote control **24** is connected to the communication jack of the overhead ionizer **18₂**, and the balance adjustment process is repeated again.

Fig. 4 is a schematic block diagram of microprocessor-controlled circuitry for operating an overhead ionizer **18**. For illustration purposes, Fig. 4 shows overhead ionizer **18₁** and ionizer **20₁** associated therewith.

The hardware components of the ionizer **20₁** include a low voltage DC fan **22₁** controlled by a DC motor **38** which draws air in through ionizing chamber **40₁**. The ionizing chamber **40₁**, which is on the intake side of the fan **22₁**, contains ion emitters (points) **42** which are removable for maintenance. The exhaust side of the fan **22₁** contains an ion balance sensor **44**. The exhaust side of the fan **22₁** distributes the ionized air containing the positive and negative ions for static neutralization. The overhead ionizer **18** is powered internally by a universal input power supply capable of operating on any input power between 100-240 VDC, 50/60 Hz. Power input is by a standard IEC320 connector, with power output available at the opposite end by a standard IEC320 outlet. These hardware components are conventional, and thus are not explained in more detail herein.

Each ionizing chamber **40** within each overhead ionizer **18** is energized by separate positive and negative high voltage power supplies **46** under the independent control of a processor **48**, which is preferably a microprocessor. The processor **48** includes a balance reference memory **50** and a comparator **52**. The memory **50** stores the balance reference values for each of the ionizers **20** associated with the overhead ionizer **18**. In the example of a three-unit overhead ionizer **18**, the memory **50** stores three voltage values, B_{REF1}, B_{REF2} and B_{REF3}. The balance reference value is the desired voltage value of the ion balance sensor **44** associated with the respective ionizer **20**. To balance an ionizer **20₁**, the measured balance, B_{MEAS1}, as determined by the ion balance sensor **44**, and B_{REF1} are compared in the comparator **52**. If the values are equal, no adjustment is made to the positive or negative high voltage power supplies **46**. If the values are not equal, appropriate adjustments are made to the power supplies **46** until the values become equal. This process occurs continuously and automatically during operation of the ionizer **20₁**. During calibration or initial setup, balance readings are taken from a charged plate monitor to obtain an actual balance reading, B_{ACTUAL1}, in the work space near the ionizer **20₁**. If the output of the comparator **52** shows that B_{REF1} equals B_{MEAS1}, and if B_{ACTUAL1} is zero, then the ionizer **20₁** is balanced and no further action is taken. However, if the output of the comparator **52** shows that B_{REF1} equals B_{MEAS1}, and if B_{ACTUAL1} is not zero, then the ionizer **20₁** is unbalanced. Accordingly, B_{REF1} is adjusted up or down by using the remote control **24**. During calibration or initial setup, the charged plate monitor is moved to obtain actual balance reading, B_{ACTUAL2} and B_{ACTUAL3}, in the work spaces near the ionizer **20₂** and **20₃**, and the process described above is repeated for such ionizers. Due to manufacturing tolerances and system degradation over time, each ionizer **20** will thus likely have a different B_{REF} value.

Each overhead ionizer **18** includes an alarm **54** for signaling when the ion balance cannot be properly controlled, and when the ion current is out of range. The processor **48** outputs the alarm signal. The alarm signals are also transmitted via the communication line **32** to the monitoring computer **34**, if such a computer is attached.

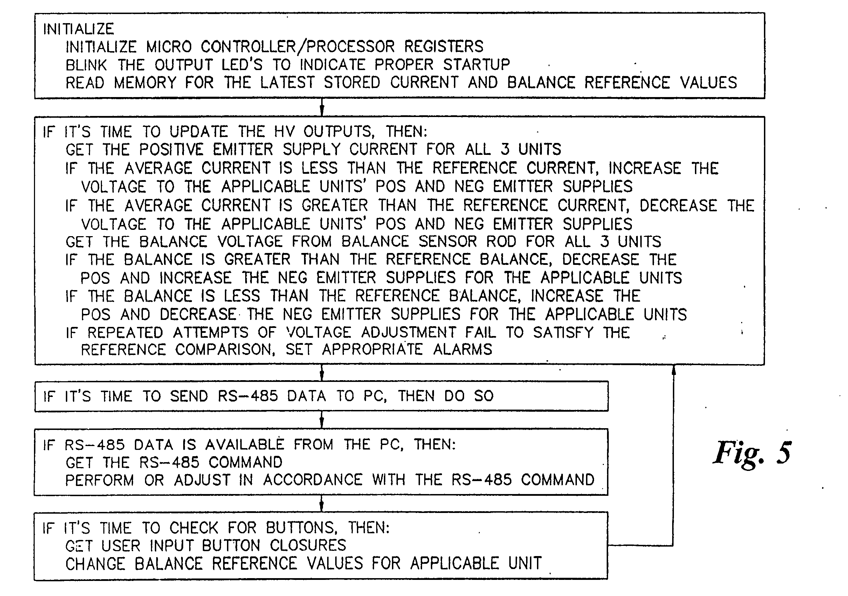

Fig. 5 is a self-explanatory flowchart of the software associated with the processor **48**.

As discussed above, conventional automatic balancing systems have hardware-based feedback systems, and suffer from at least the following problems:
(1) Such systems cannot provide very fine balance control, since feedback control signals are fixed based upon hardware component values.
(2) The overall range of balance control is limited based upon the hardware component values.
(3) Quick and inexpensive modifications are difficult to make, since the individual components are dependent upon each other for proper operation.
In contrast to conventional systems, the software-based balance control circuitry of the present invention does not suffer from any of these deficiencies.

Microprocessor control of the ionizers **20** and fans **22** within each overhead ionizer **18** allows sophisticated features to be implemented, such as the following features:
(1) The microprocessor monitors the output of the comparator for comparing each of the B_{REF} and B_{MEAS} values. If the differences are less than a predetermined value, the ionizers **20** are presumed to be making necessary small adjustments associated with normal operation. However, if one of the difference values is greater than a predetermined value at one or more instances of time, the ionizer **20** is presumed to be in need of servicing. In this instance, an alarm is output at the alarm **54** and/or the alarm is sent to the monitoring computer **34**, if such a computer is attached.
(2) When operated in a conventional, mode, the fans **22** and the ionizers **20** turn on and off simultaneously. Fan speed may be manually adjusted, if desired. When operated under microprocessor control, the processor **48** controls the fan's DC motor **38**, and fan operation may be delayed during startup and shutdown to minimize an ion imbalance. For example, during startup, the ionizers **20** may be energized to allow ion balance to stabilize before starting the fans **22**. During a shutdown, the fans **22** may be turned off and allowed to come to rest prior to deenergizing the ionizers **20**. Alternatively, the fan speed maybe ramped up or ramped down to achieve a similar effect.
(3) Automatic ion balance changes for each individual ionizer **20** may be ramped up or ramped down to avoid sudden swings or potential overshoots. For example, when using a steady-state DC mode, the DC amplitude may be gradually adjusted from a first value to the desired value to achieve the desired ramp up or down effect.

As discussed above in the background, automatic balance control systems in conventional ionizers are also inherently limited in how quickly and precisely they can achieve a short-term balanced condition and are not designed to provide long-term balanced conditions. To further illustrate these limitations, consider the example of a conventional pulse width modulation (PWM) scheme wherein fixed width (i.e., fixed frequency) pulse cycles control the positive and negative high voltage power supplies. In one such conventional PWM scheme, the pulse width of the ON/OFF cycles of the negative high voltage power supply varies, while the pulse width of the ON/OFF cycles of the positive high voltage power supply is fixed evenly between the on and off states. The driving voltages are fixed.

In operation, balance readings from an ion balance sensor are monitored and reviewed. If balance readings for recently measured cycles indicate that the balance is too negative, then the ON cycle of the negative power supply is decreased by a predetermined amount. Likewise, if balance readings for recently measured cycles indicate that the balance is too positive, then the ON cycle of the negative power supply is increased by a predetermined amount. The next set of balance readings are reviewed and further adjustments to the ON cycle of the negative power supply are made, if necessary.

Fig. 6 illustrates the prior art scheme described above. The waveform in Fig. 6 is the pulse signal associated with the negative power supply wherein a 20 millisecond (ms) pulse width is used. In an ideal balanced operating state, the ON/OFF times are equally divided between the ON and OFF states (10 ms ON, 10 ms OFF). At time t₂, the balance control system detects an imbalanced condition, specifically, an excess of negative ions. As a result, the ON cycle of the negative power supply is decreased by a predetermined amount (e.g., 1 ms) during the next 20 ms cycle, thereby providing 9 ms ON and 11 ms OFF. At time t₆, the balance control system is still detecting an excess of negative ions so the ON cycle is further decreased, for example, by another 1 ms, thereby providing 8 ms ON and 12 ms OFF. At time t₉, balance has been achieved and the next cycle remains at 8 ms ON and 12 ms OFF.

The process described above fails to provide quick short-term balance control since a plurality of cycles occur before the ionizer is brought back into balance. Typically, balance measurements from a plurality of past cycles (three cycles in the example of Fig. 6) are taken even before any corrective efforts are made. Furthermore, the corrective efforts require additional cycles before balance is achieved. The process described above also fails to provide long-term balance control. Referring to the example in Fig. 6, the balance is too negative between time t₀ and t₇. However, no effort is made to compensate for the extra negative ions generated during this time period, such as by subsequently producing extra positive ions in addition to rebalancing the ion output. Instead, balance control system works solely to reduce the excess negative ions. Thus, if the system remained in balance for the rest of the operation, or if the ionizer continually repeated the problem of producing excess negative ions, there would be a long-term imbalance of negative ions.

Other conventional schemes which also suffer from the disadvantages discussed above include using a fixed frequency and a fixed duty cycle but varying the input voltages which drive the high voltage DC supplies, and using constantly driven (steady-state) high voltage DC supplies which also vary the driving voltages.

Another important feature of the present invention is an improved balance control scheme which addresses the deficiencies described above by providing instantaneous short-term balance control and zero long-term balance control. One preferred embodiment of the improved balance control scheme works in conjunction with the overhead ionizer **18** described above with respect to Figs. 2-5. However, the scheme may be applied to any type of ionizer. Thus, the scope of the invention is not limited to the overhead ionizer application described herein.

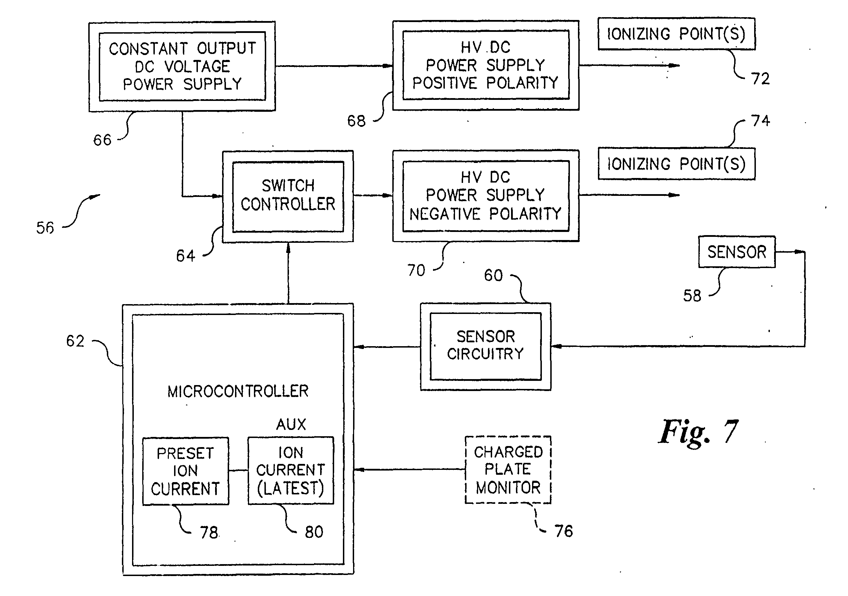

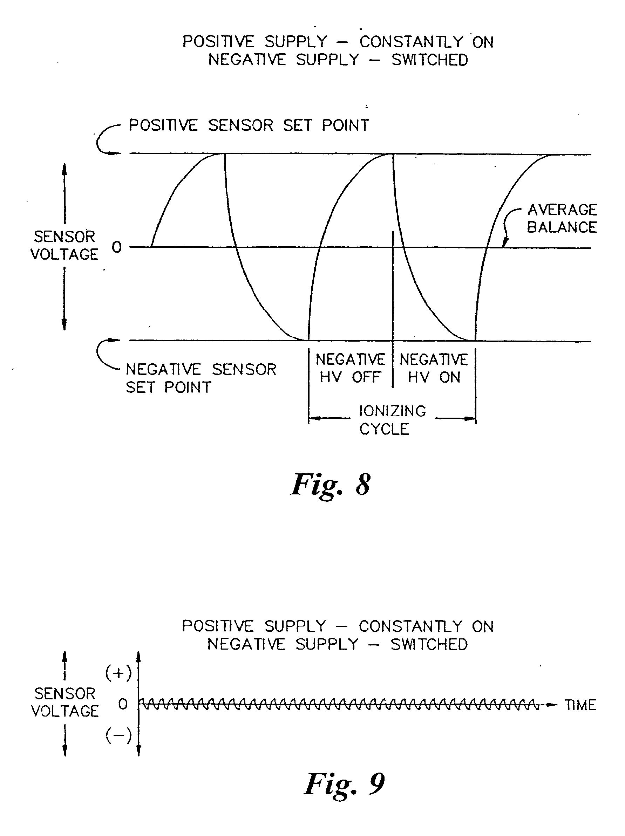

Fig. 7 is a schematic block diagram of a balance control system **56** in accordance with the present invention. Fig. 8 is a balance sensor waveform generated using the system of Fig. 7 in a first embodiment of a balance control scheme.

Referring to Fig. 7, the system **56** includes a sensor **58**, sensor circuitry **60**, a microcontroller **62**, a switch controller **64**, a constant output DC voltage power supply **66**, a positive and negative polarity HV DC power supply **68** and **70**, and respective ionizing point(s) or pin(s) **72** and **74**. An optional air moving device (not shown) may be placed near the ionizing points **72** and **74**. The sensor **58** is placed near the ionizing points **72** and **74** to provide feedback to the microcontroller **62**. That is, the output of the sensor **58** is connected to the input of the sensor circuitry **60**, and the output of the sensor circuitry **60** connects to an input of the microcontroller **62**. An output of the microcontroller **62** connects to a first input of the switch controller **64** and the output of the DC voltage power supply **66** connects to a second input of the switch controller **64**. The output of the DC voltage power supply **66** also connects to the input of the positive polarity HV DC power supply **68**. The output of the switch controller **64** connects to the input of the negative polarity HV DC power supply **70**. In this manner, the positive polarity of the HV DC power supply **68** is continuously driven at a selected input voltage (e.g., +5V), and thus has a steady state DC output. The negative polarity of the HV DC power supply **70** is driven by the DC voltage power supply **66** through the switch controller **64** under the control of the microcontroller **62**. Due to this configuration, the negative polarity HV DC power supply **70** can produce a greater quantity of ions that the positive polarity HV DC power supply **68**. The negative polarity of the HV DC power supply **70** thus switches between a high state and a low state based upon the output control signals from the microcontroller **62** which controls the switch controller **64**. In alternative embodiment of the invention, the positive polarity of the HV DC power supply **68** is switched and the negative polarity of the HV DC power supply **70** has a steady state DC output. In yet another alternative embodiment of the invention, both polarities of the HV DC power supply are switched.

In one embodiment of the present invention described below, the high state is a fully switched on state wherein power is fully switched on, and the low state is a fully switched off state wherein power is fully switched off. In alternative embodiments of the invention, the high state may be a first voltage level and the second state may be a second voltage level which is lower than the first voltage level, but not necessarily zero.

Referring to Figs. 7 and 8, the operation of the microcontroller **62** and switch controller **64** is described with respect to a sensor voltage waveform received by the microcontroller **62**.

At startup, the continuously driven positive polarity of the HV DC power supply **68** is turned fully on. The microcontroller **62** waits for the sensor **58** to exceed a predetermined but adjustable set point which is of the same polarity as the continuously driven positive power supply **68**. For example, the set point may be a voltage level, such as +2V, correlated to an electrostatic analyzer (e.g., a charged plate monitor) placed at a specific distance from the ionizing device. When the voltage level is exceeded, the microcontroller **62** sets the sensor set point to the equal but opposite polarity voltage level, such as -2V, and the negative polarity HV DC supply **70** is turned on. Next, the microcontroller **62** waits for the sensor **58** to exceed the new level (which is -2V in this example), at which time the previous sensor set point (which is +2V in this example) is loaded, and the negative polarity HV DC supply is turned off, beginning a new cycle.

A "set point" of zero is the point in which a charged plate monitor should give a balance reading of zero.

The balance control system described above may be used with the overhead ionizer **18** shown in Fig. 2A and 4. Alternatively, the balance control system may be used in other types of ionizers. If the balance control system is used in the overhead ionizer **18**, the initial set point is stored. (The positive set point is equal to BREF + an offset number, whereas the negative set point is equal to BREF - the same offset number. If, during use, the positive supply has to be adjusted from the original set value (e.g., +2V to +2.2V), then the new set point is stored for subsequent turn-on. Also, the microcontroller **62** has a memory **78** for storing a preset ion current value, as well as an auxiliary memory **80** for storing an ion current value which is the latest ion current value. During operation, if a value exists in the auxiliary memory **80**, then that value is used. If no value exists in the auxiliary memory **80**, then the value in memory **78** is used.

In a scheme wherein the switching occurs upon the sensor voltage "reaching" the set point, there is a lag time between the switching of the negative HV DC supply and the effect in the field on the actual ion balance, as measured by the sensor voltage. This effect causes the sensor voltage to slightly exceed the set point. This effect is not shown in Fig. 7.

The scheme described above is essentially a pulse width modulation form of operation. Since the sensor level controls the supplies, differences of operation from cycle to cycle are accounted for, resulting in varying frequency and duty cycle. The net result is a more stable balance control in the short-term as well as in the long-term. That is, short-term imbalance conditions are corrected in every cycle, without having to wait a plurality of cycles as required by conventional balance control schemes. In fact, the average balance is always zero in every cycle. Accordingly, the long-term average balance is also always zero. As discussed above, conventional schemes inherently do not compensate for long-term imbalanced conditions.

The scheme described in Fig. 8 operates on two reference levels (set points) and reacts according to present conditions. If something interferes with or inhibits the ionization process, no change of state occurs with respect to the negative polarity HV DC supply **70** until the proper set point is reached. This effectively lengthens the duty cycle. In contrast, if something enhances the ionization process, such as point cleaning, the set point limits are reached more quickly, resulting in a reduced duty cycle. The overall "frequency" is based upon the sensor set points, with higher set points resulting in a slower frequency. That is, the longer it takes to reach the set point, the less cycles will occur in a given period of time.

The balance control system of the present invention allows the user to monitor the condition of the constantly driven HV DC supply (positive supply in the embodiment of Fig. 8) and to adjust for ionizing point wear. For example, a reduction in the output voltage of the positive supply may be detected by a reduction in the duty cycle of the negative supply.

Fig. 9 is a balance sensor waveform generated using the system of Fig. 7 in a second embodiment of a balance control scheme. In the scheme of Fig. 9, there is a single set point. The negative supply is turned on when the output voltage of the ion balance sensor **58** exceeds the set point in a first direction (e.g., positive direction) by a first predetermined amount, and the negative supply is turned off when the output voltage of the ion balance sensor **58** exceeds the set point in a second direction (e.g., negative direction) by a second predetermined amount The first and second predetermined amounts may be the same, as shown in Fig. 9, or they may be different amounts. The single set point voltage is the voltage which causes a zero voltage on a charged plate monitor (CPM) at a particular distance from the ionizer, such as 18 inches. In the example of Fig. 9, the set point voltage is zero. The resultant sensor voltage waveform has a sinusoidal appearance. The lag time between the switching of the negative HV DC supply and the effect in the field on the actual ion balance, as measured by the sensor voltage, contributes to the sinusoidal waveform. The scheme in Fig. 9 provides faster corrections for imbalance than the scheme in Fig. 8, assuming that the processing speed of the sensor voltage checking process and the response time of the negative polarity high voltage power supply are the same in both schemes.

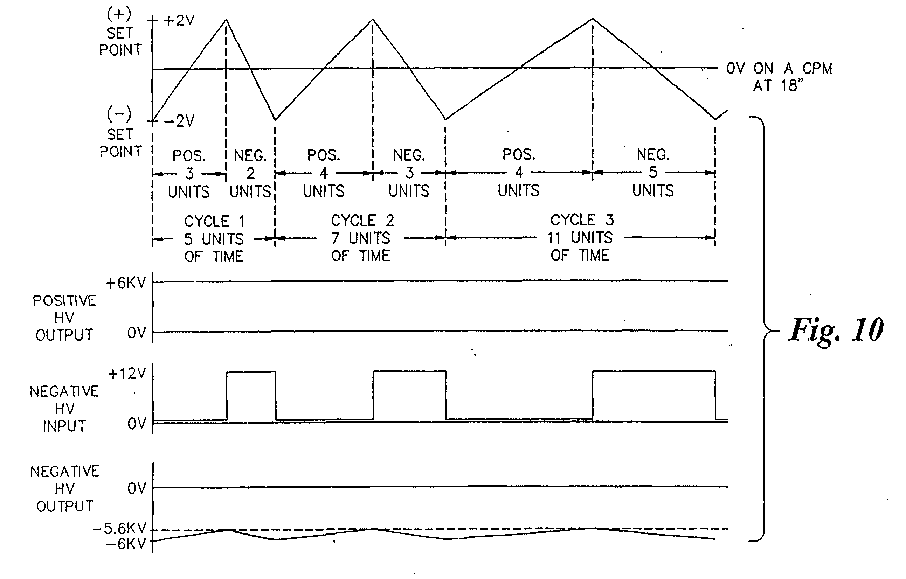

Fig. 10 is a combined diagram of waveforms associated with the sensor and power supplies of Fig. 7 in a further illustration of the balance control system. Some of the waveforms in Fig. 10 are exaggerated or simplified to illustrate the invention. Fig. 10 illustrates a two sensor set point scheme, similar to Fig. 8.

The first waveform in Fig. 10 is a balance sensor waveform and shows how duty cycle and frequency may vary to maintain a balanced condition. The second waveform shows the constant output of the constantly on positive polarity HV DC supply **68**. The third waveform shows the input voltage of the negative polarity HV DC supply **70** (i.e. the drive voltage of the negative polarity HV DC supply **70**). The fourth waveform shows the output of the negative polarity HV DC supply **70**. Due to the stored energy in the power supply **70**, the output voltage does not turn completely on and off even though the input drive voltage turns completely on and off. Instead, the output voltage rises and falls from a maximum output voltage as the drive voltage switches on and off. In the example of Fig. 10, the output voltage varies between -5.6 kV and -6.0 kV as the drive voltage varies between 0V and 12V. Other switching schemes are within the scope of the invention. For example, as discussed above, the switched power supply may have its input voltage switched between any two input voltage levels, not necessarily a fully switched off and fully switched on level.

Alternative schemes which use the same inventive principle and achieve the same goal as the schemes described above are within the scope of the invention. Some variations are as follows:
1. The positive polarity HV DC supply may be switched and the negative polarity HV DC supply may be constantly driven.
2. The positive and negative polarity HV DC supplies may both be switched. In the schemes of Figs. 8 and 9, the positive supply would be switched on whenever the negative supply is switched off, and vice-versa. This scheme would allow for faster balancing but would require more complex and expensive switching circuitry and software control.
3. A charged plate monitor **76** may be used in place of the sensor **58** to provide the data for the microcontroller **62** to generate the switching signals.

In experiments conducted with conventional balance control systems and the balance control system of the present invention, short-term tests show that charged plate monitor readings in conventional systems vary between ± 5-10 volts, wherein readings taken using the balance control system of the present invention vary between ± 2-3 volts.

## Claims

1. A method of balancing positive and negative ion output in an electrical ionizer having (i) positive and negative ion emitters, and (ii) positive and negative high voltage power supplies associated with the respective positive and negative ion emitters, at least one of the positive and negative high voltage power supplies switching between a high state and a low state, the method comprising:
(a) providing an ion balance sensor located close to the ion emitters, the ion balance sensor outputting a voltage value;
(b) storing an ion balance sensor set point voltage value, the voltage value being set to provide a balanced ion condition in the work space near the electrical ionizer ;
(c) during operation of the electrical ionizer, comparing the output voltage value of the ion balance sensor with the set point voltage value;
(d) switching one of the switchable high voltage power supplies to a high state when it is detected as a result of the comparison that the output voltage value of the ion balance sensor exceeds the set point voltage value in a first direction by a first predetermined amount; and
(e) switching the one of the switchable high voltage power supplies to a low state when it is detected as a result of the comparison that the output voltage value of the ion balance sensor exceeds the set point voltage value in a second direction by a second predetermined amount, the second direction being opposite of the first direction.

2. A method according to claim 1 wherein one of the positive and negative high voltage power supplies has a steady state DC output, and the other of the positive and negative high voltage power supplies switches between a high state and a low state,
wherein step (d) comprises switching the switchable high voltage power supply to a high state when it is detected as a result of the comparison that the output voltage value of the ion balance sensor exceeds the set point voltage value in a first direction by a first predetermined amount; and
wherein step (e) comprises switching the switchable high voltage power supply to a low state when it is detected as a result of the comparison that the output voltage value of the ion balance sensor exceeds the set point voltage value in a second direction by a second predetermined amount.

3. A method according to claim 1 or 2 wherein the positive high voltage power supply has a steady state DC output, and the negative high voltage power supply switches between a high state and a low state, and steps (d) and (e) switch the negative high voltage power supply to the high and low states.

4. A method according to at least one of the preceding claims wherein the positive and negative high voltage power supplies both switch between a high state and a low state,
wherein step (d) further comprises switching the other of the switchable high voltage power supplies to a low state when it is detected as a result of the comparison that the output voltage value of the ion balance sensor exceeds the set point voltage value in a first direction by a first predetermined amount; and
wherein step (e) further comprises switching the other of the switchable high voltage power supplies to a high state when it is detected as a result of the comparison that the output voltage value of the ion balance sensor exceeds the set point voltage value in a second direction by a second predetermined amount.

5. A method according to at least one of the preceding claims wherein the high state provides fully switched on input power to the at least one switchable high voltage power supply, and the low state provides fully switched off input power to the at least one switchable high voltage power supply.

6. A method according to at least one of preceding claims wherein the high state provides a first input voltage to the at least one switchable high voltage power supply, and the low state provides a second input voltage lower than the first input voltage to the at least one switchable high voltage power supply.

7. A method according to at least one of the preceding claims wherein the first and second predetermined values are identical.

8. A method of balancing positive and negative ion output in an electrical ionizer having (i) positive and negative ion emitters, and (ii) positive and negative high voltage power supplies associated with the respective positive and negative ion emitters, at least one of the positive and negative high voltage power supplies switching between a high state and a low state, the method comprising:
(a) providing an ion balance sensor located close to the ion emitters, the ion balance sensor outputting a voltage value;
(b) storing a positive ion balance-sensor set point voltage value and a negative ion balance sensor set point voltage value;
(c) during operation of the electrical ionizer, comparing the output voltage value of the ion balance sensor with the positive and negative set point voltage values;
(d) switching one of the switchable high voltage power supply to a high state when it is detected as a result of the comparison that the output voltage value of the ion balance sensor exceeds one of the positive and negative set point voltage values; and
(e) switching the one of the switchable high voltage power supplies to a low state when it is detected as a result of the comparison that the output voltage value of the ion balance sensor exceeds the other of the positive and negative set point voltage values.

9. A method according to claim 8 wherein one of the positive and negative high voltage power supplies has a steady state DC output, and the other of the positive and negative high voltage power supplies that switches between a high state and a low state,
wherein step (d) comprises switching the switchable high voltage power supply to a high state when it is detected as a result of the comparison that the output voltage value of the ion balance sensor exceeds one of the positive and negative set point voltage values; and
wherein step (e) comprises switching the switchable high voltage power supplies to a low state when it is detected as a result of the comparison that the output voltage value of the ion balance sensor exceeds the other of the positive and negative set point voltage values.

10. A method according to claim 8 or 9 wherein the positive high voltage power supply has a steady state DC output, and the negative high voltage power supply switches between a high state and a low state, and step (d) switches the negative high voltage power supply to the high state when the ion balance sensor exceeds the positive set point voltage value, and step (e) switches the negative high voltage power supply to the low state when the ion balance sensor exceeds the negative set point voltage value.

## Patentansprüche

1. Verfahren zum Ausgleichen der positiven und negativen Ionenausgabe in einem elektrischen Ionisator mit (i) einem positiven und einem negativen Ionenemitter und (ii) einer positiven und einer negativen Hochspannungs-Stromversorgung, die mit dem jeweiligen positiven bzw. negativen Ionenemitter assoziiert sind, wobei mindestens eine der positiven und der negativen Hochspannungs-Stromversorgung zwischen einem Hoch-Zustand und einem Niedrig-Zustand umschaltet, wobei das Verfahren die folgenden Schritte umfaßt:
(a) Bereitstellen eines in der Nähe der Ionenemitter angeordneten Ionenausgleichssensors, wobei der Ionenausgleichssensor einen Spannungswert ausgibt;
(b) Speichern eines Sollspannungswerts des Ionenausgleichssensors, wobei der Spannungswert so eingestellt wird, daß ein ausgeglichener Ionenzustand in dem Arbeitsraum in der Nähe des elektrischen Ionisators entsteht;
(c) während des Betriebs des elektrischen Ionisators, Vergleichen des Ausgangsspannungswerts des Ionenausgleichssensors mit dem Sollspannungswert;
(d) Umschalten einer der umschaltbaren Hochspannungs-Stromversorgungen in einen Hoch-Zustand, wenn als Ergebnis des Vergleichs detektiert wird, daß der Ausgangsspannungswert des Ionenausgleichssensors den Sollspannungswert in einer ersten Richtung um einen ersten vorbestimmten Betrag überschreitet; und
(e) Umschalten der einen umschaltbaren Hochspannungs-Stromversorgurigen in einen Niedrig-Zustand, wenn als Ergebnis des Vergleichs detektiert wird, daß der Ausgangsspannungswert des Ionenausgleichssensors den Sollspannungswert in einer zweiten Richtung um einen zweiten vorbestimmten Betrag überschreitet, wobei die zweite Richtung der ersten Richtung entgegengesetzt ist.

2. Verfahren nach Anspruch 1, wobei eine der positiven und der negativen Hochspannungs-Stromversorgung eine stationäre Gleichstromausgabe liefert und die andere der positiven und der negativen Hochspannungs-Stromversorgung zwischen einem Hoch-Zustand und einem Niedrig-Zustand umschaltet,
wobei Schritt (d) umfaßt, die umschaltbare Hochspannungs-Stromversorgung in einen Hoch-Zustand umzuschalten, wenn als Ergebnis des Vergleichs detektiert wird, daß der Ausgangsspannungswert des Ionenausgleichssensors den Sollspannungswert in einer ersten Richtung um einen ersten vorbestimmten Betrag überschreitet; und
wobei Schritt (e) umfaßt, die umschaltbare Hochspannungs-Stromversorgung in einen Niedrig-Zustand umzuschalten, wenn als Ergebnis des Vergleichs detektiert wird, daß der Ausgangsspannungswert des Ionenausgleichssensors den Sollspannungswert in einer zweiten Richtung um einen zweiten vorbestimmten Betrag überschreitet.

3. Verfahren nach Anspruch 1 oder 2, wobei die positive Hochspannungs-Stromversorgung eine stationäre Gleichstromausgabe liefert und die negative Hochspannungs-Stromversorgung zwischen einem Hoch-Zustand und einem Niedrig-Zustand umschaltet, und die Schritte (d) und (e) die negative Hochspannungs-Stromversorgung in den Hoch- und den Niedrig-Zustand umschalten.

4. Verfahren nach mindestens einem der vorhergehenden Ansprüche, wobei die positive und die negative Hochspannungs-Stromversorgung beide zwischen einem Hoch-Zustand und einem Niedrig-Zustand umschalten,
wobei Schritt (d) ferner umfaßt, die andere der umschaltbaren Hochspannungs-Stromversorgungen in einen Niedrig-Zustand umzuschalten, wenn als Ergebnis des Vergleichs detektiert wird, daß der Ausgangsspannungswert des Ionenausgleichssensors den Sollspannungswert in einer ersten Richtung um einen ersten vorbestimmten Betrag überschreitet; und
wobei Schritt (e) ferner umfaßt, die andere der umschaltbaren Hochspannungs-Stromversorgungen in einen Hoch-Zustand umzuschalten, wenn als Ergebnis des Vergleichs detektiert wird, daß der Ausgangsspannungswert des Ionenausgleichssensors den Sollspannungswert in einer zweiten Richtung um einen zweiten vorbestimmten Betrag überschreitet.

5. Verfahren nach mindestens einem der vorhergehenden Ansprüche, wobei der Hoch-Zustand der mindestens einen umschaltbaren Hochspannungs-Stromversorgung voll eingeschalteten Eingangsstrom zuführt und der Niedrig-Zustand der mindestens einen umschaltbaren Hochspannungs-Stromversorgung voll ausgeschalteten Eingangsstrom zuführt.

6. Verfahren nach mindestens einem der vorhergehenden Ansprüche, wobei der Hoch-Zustand der mindestens einen umschaltbaren Hochspannungs-Stromversorgung eine erste Eingangsspannung zuführt und der Niedrig-Zustand der mindestens einen umschaltbaren Hochspannungs-Stromversorgung eine zweite Eingangsspannung zuführt, die kleiner als die erste Eingangsspannung ist.

7. Verfahren nach mindestens einem der vorhergehenden Ansprüche, wobei der erste und der zweite vorbestimmte Wert gleich sind.

8. Verfahren zum Ausgleichen der positiven und negativen Ionenausgabe in einem elektrischen Ionisator mit (i) einem positiven und einem negativen Ionenemitter und (ii) einer positiven und einer negativen Hochspannungs-Stromversorgung, die mit dem jeweiligen positiven bzw. negativen Ionenemitter assoziiert sind, wobei mindestens eine der positiven und der negativen Hochspannungs-Stromversorgung zwischen einem Hoch-Zustand und einem Niedrig-Zustand umschaltet, wobei das Verfahren die folgenden Schritte umfaßt:
(a) Bereitstellen eines in der Nähe der Ionenemitter angeordneten Ionenausgleichssensors, wobei der Ionenausgleichssensor einen Spannungswert ausgibt;
(b) Speichern eines positiven Sollspannungswerts des Ionenausgleichssensors und eines negativen Sollspannungswerts des Ionenausgleichssensors;
(c) während des Betriebs des elektrischen Ionisators, Vergleichen des Ausgangsspannungswerts des Ionenausgleichssensors mit dem positiven und dem negativen Sollspannungswert;
(d) Umschalten einer der umschaltbaren Hochspannungs-Stromversorgungen in einen Hoch-Zustand, wenn als Ergebnis des Vergleichs detektiert wird, daß der Ausgangsspannungswert des Ionenausgleichssensors einen des positiven und des negativen Sollspannungswerts überschreitet; und
(e) Umschalten der einen umschaltbaren Hochspannungs-Stromversorgungen in einen Niedrig-Zustand, wenn als Ergebnis des Vergleichs detektiert wird, daß der Ausgangsspannungswert des Ionenausgleichssensors den anderen des positiven und des negativen Sollspannungswerts überschreitet.

9. Verfahren nach Anspruch 8, wobei eine der positiven und der negativen Hochspannungs-Stromversorgung eine stationäre Gleichstromausgabe liefert und die andere der positiven und der negativen Hochspannungs-Stromversorgung zwischen einem Hoch-Zustand und einem Niedrig-Zustand umschaltet,
wobei Schritt (d) umfaßt, die umschaltbare Hochspannungs-Stromversorgung in einen Hoch-Zustand umzuschalten, wenn als Ergebnis des Vergleichs detektiert wird, daß der Ausgangsspannungswert des Ionenausgleichssensors einen des positiven und des negativen Sollspannungswerts überschreitet; und
wobei Schritt (e) umfaßt, die umschaltbare Hochspannungs-Stromversorgung in einen Niedrig-Zustand umzuschalten, wenn als Ergebnis des Vergleichs detektiert wird, daß der Ausgangsspannungswert des Ionenausgleichssensors den anderen des positiven und des negativen Sollspannungswerts überschreitet.

10. Verfahren nach Anspruch 8 oder 9, wobei die positive Hochspannungs-Stromversorgung eine stationäre Gleichstromausgabe liefert und die negative Hochspannungs-Stromversorgung zwischen einem Hoch-Zustand und einem Niedrig-Zustand umschaltet, und Schritt (d) die negative Hochspannungs-Stromversorgung in den Hoch-Zustand umschaltet, wenn der Ionenausgleichssensor den positiven Sollspannungswert überschreitet, und Schritt (e) die negative Hochspannungs-Stromversorgung in den Niedrig-Zustand umschaltet, wenn der Ionenausgleichssensor den negativen Sollspannungswert überschreitet.

## Revendications

1. Procédé pour équilibrer la sortie d'ions positifs et négatifs dans un ioniseur électrique ayant (i) des émetteurs d'ions positifs et négatifs, et (ii) des alimentations électriques de haute tension positive et négative associées aux émetteurs d'ions positifs et négatifs respectifs, une au moins des alimentations électriques de haute tension positive et négative commutant entre un état haut et un état bas, le procédé comprenant :
(a) la fourniture d'un capteur d'équilibre ionique placé à proximité des émetteurs d'ions, le capteur d'équilibre ionique fournissant en sortie une valeur de tension ;
(b) le stockage d'une valeur de tension du point de réglage du capteur d'équilibre ionique, la valeur de tension étant réglée pour fournir une condition ionique équilibrée dans l'espace de travail proche de l'ioniseur électrique ;
(c) pendant le fonctionnement de l'ioniseur électrique, la comparaison de la valeur de tension en sortie du capteur d'équilibre ionique avec la valeur de tension du point de réglage ;
(d) la commutation d'une des alimentations électriques de haute tension commutables vers un état haut lorsqu'on détecte, comme résultat de la comparaison, une valeur de tension en sortie du capteur d'équilibre ionique qui dépasse la valeur de tension du point de réglage dans une première direction d'une première quantité prédéterminée ; et
(e) la commutation d'une des alimentations électriques de haute tension commutables vers un état bas lorsqu'on détecte, comme résultat de la comparaison, une valeur de tension en sortie du capteur d'équilibre ionique qui dépasse la valeur de tension du point de réglage dans une seconde direction d'une seconde quantité prédéterminée, la seconde direction étant opposée à la première direction.

2. Procédé selon la revendication 1, dans lequel une des alimentations électriques de haute tension positive et négative a une tension de sortie continue fixe alors que l'autre des alimentations électriques de haute tension positive et négative commute entre un état haut et un état bas,
dans lequel l'étape (d) comprend la commutation vers un état haut de l'alimentation électrique de haute tension commutable lorsqu'on détecte, comme résultat de la comparaison, une valeur de tension en sortie du capteur d'équilibre ionique qui dépasse la valeur de tension du point de réglage dans une première direction d'une première quantité prédéterminée ; et
dans lequel l'étape (e) comprend la commutation vers un état bas de l'alimentation électrique de haute tension commutable lorsqu'on détecte, comme résultat de la comparaison, une valeur de tension en sortie du capteur d'équilibre ionique qui dépasse la valeur de tension du point de réglage dans une seconde direction d'une seconde quantité prédéterminée.

3. Procédé selon la revendication 1 ou 2, dans lequel l'alimentation électrique de haute tension positive a une tension de sortie continue fixe alors que l'alimentation électrique de haute tension négative commute entre un état haut et un état bas, et les étapes (d) et (e) commutent l'alimentation électrique de haute tension négative vers les états haut et bas.

4. Procédé selon une au moins des revendications précédentes, dans lequel les alimentations électriques de haute tension positive et négative commutent toutes deux entre un état haut et un état bas,
dans lequel l'étape (d) comprend de plus la commutation des autres alimentations électriques de haute tension commutables vers un état bas lorsqu'on détecte, comme résultat de la comparaison, une valeur de tension en sortie du capteur d'équilibre ionique qui dépasse la valeur de tension du point de réglage dans une première direction d'une première quantité prédéterminée ; et
dans lequel l'étape (e) comprend de plus la commutation des autres alimentations électriques de haute tension commutables vers un état haut lorsqu'on détecte, comme résultat de la comparaison, une valeur de tension en sortie du capteur d'équilibre ionique qui dépasse la valeur de tension du point de réglage dans une seconde direction d'une seconde quantité prédéterminée.

5. Procédé selon une au moins des revendications précédentes, dans lequel l'état haut fournit une puissance d'entrée totalement enclenchée à une au moins des alimentations électriques de haute tension commutables, et l'état bas fournit une puissance d'entrée totalement déclenchée à une au moins des alimentations électriques de haute tension commutables.

6. Procédé selon une au moins des revendications précédentes, dans lequel l'état haut fournit une première tension d'entrée à une au moins des alimentations électriques de haute tension commutables, et l'état bas fournit une seconde tension d'entrée inférieure à la première tension d'entrée à une au moins des alimentations électriques de haute tension commutables.

7. Procédé selon une au moins des revendications précédentes, dans lequel la première et la seconde valeur prédéterminée sont identiques.

8. Procédé pour équilibrer la sortie d'ions positifs et négatifs dans un ioniseur électrique ayant (i) des émetteurs d'ions positifs et négatifs, et (ii) des alimentations électriques de haute tension positive et négative associées aux émetteurs d'ions positifs et négatifs respectifs, une au moins des alimentations électriques de haute tension positive et négative commutant entre un état haut et un état bas, le procédé comprenant :
(a) la fourniture d'un capteur d'équilibre ionique placé à proximité des émetteurs d'ions, le capteur d'équilibre ionique fournissant en sortie une valeur de tension;
(b) le stockage d'une valeur de tension positive du point de réglage du capteur d'équilibre ionique et d'une valeur de tension négative du point de réglage du capteur d'équilibre ionique ;
(c) pendant le fonctionnement de l'ioniseur électrique, la comparaison de la valeur de tension en sortie du capteur d'équilibre ionique avec les valeurs de tension positive et négative du point de réglage ;
(d) la commutation d'une des alimentations électriques de haute tension commutables vers un état haut lorsqu'on détecte, comme résultat de la comparaison, une valeur de tension en sortie du capteur d'équilibre ionique qui dépasse une des valeurs de tension positive et négative du point de réglage ; et
(e) la commutation d'une des alimentations électriques de haute tension commutables vers un état bas lorsqu'on détecte, comme résultat de la comparaison, une valeur de tension en sortie du capteur d'équilibre ionique qui dépasse l'autre des valeurs de tension positive et négative du point de réglage.

9. Procédé selon la revendication 8, dans lequel une des alimentations électriques de haute tension positive et négative a une tension de sortie continue fixe alors que l'autre des alimentations électriques de haute tension positive et négative commute entre un état haut et un état bas,
dans lequel l'étape (d) comprend la commutation vers un état haut de l'alimentation électrique de haute tension commutable lorsqu'on détecte, comme résultat de la comparaison, une valeur de tension en sortie du capteur d'équilibre ionique qui dépasse une des valeurs de tension positive et négative du point de réglage ; et
dans lequel l'étape (e) comprend la commutation vers un état bas de l'alimentation électrique de haute tension commutable lorsqu'on détecte, comme résultat de la comparaison, une valeur de tension en sortie du capteur d'équilibre ionique qui dépasse l'autre des valeurs de tension positive et négative du point de réglage.

10. Procédé selon la revendication 8 ou 9, dans lequel l'alimentation électrique de haute tension positive a une tension de sortie continue fixe alors que l'alimentation électrique de haute tension négative commute entre un état haut et un état bas, et l'étape (d) commute l'alimentation électrique de haute tension négative vers l'état haut lorsque le capteur d'équilibre ionique dépasse la valeur de tension positive du point de réglage, et l'étape (e) commute l'alimentation électrique de haute tension négative vers l'état bas lorsque le capteur d'équilibre ionique dépasse la valeur de tension négative du point de réglage.
